# EUROPÄISCHE PATENTSCHRIFT

(11) **EP 1 441 579 B1**
(45) Veröffentlichungstag und Bekanntmachung des Hinweises auf die Patenterteilung: **12.10.2005**
(21) Anmeldenummer: 03001015.1
(22) Anmeldetag: 17.01.2003
(51) Int. Cl.: H05K 7/14

(54) **Kopf- oder Bodenteil für einen Baugruppenträger**
Top or bottom plate for a rack
Elément de couvercle ou de fond d'une baie électronique

(43) Veröffentlichungstag der Anmeldung: 28.07.2004
(73) Patentinhaber: Schroff GmbH, D-75334 Straubenhardt (DE)
(72) Erfinder: Weller, Hans-Jörg, 76275 Ettlingen (DE); Lenkisch, Andreas, 75180 Pforzheim (DE); Haag, Volker, 75323 Bad Wildbad (DE); Joist, Michael, 76571 Gaggenau (DE)
(74) Vertreter: Durm, Frank

(56) Entgegenhaltungen:
- DE-A- 3 112 596
- US-A- 4 007 403
- US-A- 4 232 356
- US-A- 4 323 161
- US-A- 4 779 744
- US-A- 5 805 429
- US-B1- 6 185 109

## Beschreibung

Die Erfindung betrifft ein Kopf- oder Bodenteil aus Metallblech für einen Baugruppenträger, mit einem umlaufenden Rahmen und mit zwischen der vorderen und hinteren Rahmenleiste angeordneten und in Einschubrichtung ausgerichteten Führungsschienen zur Aufnahme einer Leiterplatte einer Steckbaugruppe, wobei die Führungsschienen im Querschnitt U-förmig ausgebildet sind und einen Boden und zwei Seitenwände umfassen.

Elektronische und elektrische Geräte der Industrieelektronik sind in Form von modularen Baugruppenträgern aufgebaut. Die Baugruppenträger dienen zur Aufnahme von einsteckbaren elektronischen Steckbaugruppen, die in dafür vorgesehene Steckplätze eingeschoben werden. In ihrer einfachsten Form bestehen die Baugruppenträger aus zwei Seitenwänden und vier parallelen Modulschienen, welche mit ihren Stirnflächen an die beiden Seitenwände angrenzen. Ein Deckblech und ein Bodenblech sowie eine Rückwand können den Baugruppenträger zu einem Gehäuse ergänzen. Von der offenen Frontseite her werden die Steckbaugruppen auf Führungsschienen eingeschoben, die zumeist einzeln an der vorderen und hinteren Modulschiene befestigt sind.

Auf die Modulschienen aufgesteckte Führungsschienen sind in der Regel aus Kunststoff hergestellt und derart an den Modulschienen befestigt, dass die Teilfrontplatten der eingesteckten Steckbaugruppen aneinandergrenzen. Durch eine variable Anordnung der Führungsschienen können Steckbaugruppen mit unterschiedlich breiten Teilfrontplatten miteinander kombiniert werden. Auch ist eine nachträgliche Verlegung der Führungsschienen mit geringem Aufwand möglich. Derartige Führungsschienen zur Aufnahme von Steckbaugruppen beschreibt beispielsweise die US 4 323 161. Mehrere Führungsschienen werden voneinander beabstandet in einem rahmenartigen Baugruppenträger montiert. Die Führungsschienen selbst sind in der Mitte abgeflacht und aufgebogen, so dass eine sattelartige Verformung entsteht. Die Verformung ist stets in der Mitte der Führungsschiene angeordnet. Damit soll die seitliche Steifigkeit der einzelnen Führungsschienen verbessert werden.

In vielen elektronischen Systemen ist eine variable Anordnung der einzelenen Führungsschienen nicht notwendig, so dass auf den relativ teuren, aus vielen Einzelteilen bestehenden Aufbau eines Baugruppenträgers herkömmlicher Art verzichtet werden kann. Gerade das manuelle, nachträgliche Einsetzen der Führungsschienen erhöht die Herstellungskosten solcher Baugruppenträger erheblich. Aus Kostengründen werden deshalb in zunehmendem Maße die Boden- und Kopfgruppen der Baugruppenträger nicht mehr aus einer Vielzahl von Einzelteilen hergestellt. Statt dessen wird das ganze Boden- bzw. Kopfteil des Baugruppenträgers aus einem einzigen Bauteil gefertigt, das die Modulschienen, das Boden- bzw. Deckblech und die Führungsschienen umfasst.

Ein solches integriertes Boden- bzw. Kopfteil besteht im Prinzip aus einem rechteckigen Metallblech, dessen Ränder einfach oder mehrfach abgekantet sind. Die Abkantungen dienen zum einen zur Versteifung; zum anderen bieten sie eine Anlagefläche für die Seitenteile des Baugruppenträgers und stellen Befestigungspunkte für die angrenzenden Teile dar. Aus der Fläche des Metallblechs werden die Führungsschienen herausgearbeitet. Dazu werden in das Blech Schlitze derart eingearbeitet, dass ein umlaufender Rahmen und zwischen der vorderen und hinteren Rahmenleiste parallel verlaufende Stege entstehen. Die Breite jedes Steges entspricht der Breite des Bodens einer Führungsschiene plus der Höhe der beiden Seitenwände der Führungsschiene. Die Seitenwände der Führungsschiene werden aus den Stegen um 90 Grad herausgebogen, so dass eine U-förmige Führungsschiene entsteht. Zwei benachbarte Führungsschienen sind wenigstens im Abstand der doppelten Höhe der Seitenwände der Führungsschiene angeordnet. Bei einem größeren Abstand zwischen zwei benachbarten Führungsschienen können die verbleibenden Flächen entfernt werden, wenn beispielsweise eine verbesserte Belüftung des Baugruppenträgers gefordert ist. Dies kann insbesondere beim Einsatz von modernen Steckbaugruppen mit hohen Taktfrequenzen oder mit großer Leistungsaufnahme erforderlich sein.

Modulschienen als integrierte Bestandteile des Deckblechs bzw. des Bodenblechs sind beispielsweise in DE 198 17 089 C1 beschrieben. In der US 6 185 109 B1 ist ebenfalls ein Baugruppenträger offenbart, dessen obere und untere Deckplatte als einstückiger metallischer Führungsrost ausgebildet ist. Der Führungsrost weist eine Mehrzahl von Führungsschienen zur Aufnahme von elektronischen Steckbaugruppen auf und hat zwischen den Führungsschienen angeordnete Öffnungen.

Moderne Steckbaugruppen in elektrischen und elektronischen Systemen enthalten hochintegrierte Halbleiterbauelemente und sind somit besonders gegen elektrostatische Entladungen gefährdet. Durch die niedrigen Schaltpegel in den elektronischen Schaltungen bei gleichzeitig sehr hohen Taktfrequenzen und entsprechend kurzen Einstiegszeiten der Logikbauteile können schon relativ kleine Ladungen zu Störungen auf der Leiterplatte oder sogar zum Zerstören von einzelnen Komponenten führen. Gerade unter ungünstigen klimatischen Bedingungen können sich schnell hohe Ladungen auf den Steckbaugruppen ansammeln. Beim Einschieben der Steckbaugruppen in den Baugruppenträger, spätestens jedoch, wenn die Steckbaugruppe mit der Rückverdrahtungsplatine des Baugruppenträgers kontaktiert wird, gleichen sich dann die Potentiale zwischen der aufgeladenen Steckbaugruppe und dem auf Massepotential liegenden Baugruppenträger schlagartig aus. Dadurch können kurzzeitige extrem hohe Entladungsströme auftreten, die zu Beschädigungen oder Zerstörungen führen.

Um ein unkontrolliertes Entladen der Steckbaugruppe beim Einschieben in den Baugruppenträger zu vermeiden, wird üblicherweise am unteren Rand der Leiterplatte ein streifenförmiger metallischer Bereich vorgesehen. Dieser Kontaktstreifen am unteren Rand ist in mehrere Abschnitte, sogenannte Segmente, untergliedert. Diese Segmente sind mit unterschiedlichen Bereichen der Leiterplatte galvanisch verbunden. Beispielsweise ist ein Segment mit dem Logikteil der Steckbaugruppe verbunden, ein weiteres mit den Masseflächen. In der Regel ist auch die Frontplatte der Steckbaugruppe galvanisch mit einem speziellen Segment am unteren Rand der Leiterplatte kontaktiert.

In den Führungsschienen der Baugruppenträger ist üblicherweise ein Kontaktelement integriert. Das Kontaktelement ist in der Regel als Kontaktfeder ausgebildet und befindet sich am vorderen Ende der Führungsschiene. Das Kontaktelement ist mit dem Baugruppenträger leitend verbunden.

Beim Einschieben der Steckbaugruppe in den Baugruppenträger schleifen nun die einzelnen Segmente im unteren Rand der Leiterplatten an dem Kontaktelement der Führungsschiene vorbei, so dass die mit den Segmenten verbundenen Bereiche auf der Leiterplatte nacheinander und unabhängig voneinander kontrolliert entladen werden. Hierzu können auf der Leiterplatte Widerstände im Entladepfad angeordnet sein, die dazu dienen, den Entladestrom auf ein zulässiges und für die Steckbaugruppe verträgliches Maß zu begrenzen.

Bei Baugruppenträgern, bei denen das ganze Boden- bzw. Kopfteil aus einem Stück Blech gefertigt ist, sind die Führungsschienen ebenso aus Metall ausgebildet wie die Seitenwände des Baugruppenträgers. Wird in diese durchgängig metallischen Führungsschienen eine Steckbaugruppe eingeschoben, so kommt es zu Problemen: Die einzelnen Segmente am unteren Rand der Leiterplatte werden durch die metallisch leitende Seitenwände der Führungsschienen untereinander verbunden und somit kurzgeschlossen. Damit werden auch die einzelnen Logikteile und Masseflächen auf der Leiterplatte galvanisch miteinander verbunden. Dies kann in ungünstigen Fällen nicht nur zu Störungen, sondern durchaus auch zu einer Zerstörung der Steckbaugruppe oder einzelner elektronischer Komponenten führen.

Um solche Kurzschlüsse zu vermeiden, werden die Seitenwände der Führungsschienen in den Bereichen entfernt, die mit den leitfähigen Segmenten am Rand der Leiterplatte korrespondieren. Dadurch wird vermieden, dass die Logikteile und die spannungsführenden Teile der Leiterplatte mit der Gehäusemasse geerdet werden. Unter Umständen müssen die Ausnehmungen in den Seitenwänden der Führungsschienen recht groß sein. Nachteilig ist dabei, dass die Ausnehmungen der Seitenwände die Steifigkeit der Führungsschienen drastisch verringern. Unachtsam eingeschobene Steckbaugruppen bewirken ein Verbiegen oder führen zu Beschädigungen an den einzelnen Führungsschienen. In Einzelfällen können die Führungsschienen sogar brechen.

Nachteilig erweist sich weiterhin, dass sich die Steckbaugruppen beim Einschieben in den Baugruppenträger leicht an den Ausnehmungen der Seitenwände der Führungsschienen verhaken können. Ein glattes und reibungsloses Hineinschieben der Steckbaugruppen in den Baugruppenträger ist dann nicht mehr gewährleistet. Vielmehr muss die Steckbaugruppe durch Hin- und Herbewegen vorsichtig in die Führungsschiene eingeschoben werden. Das Verhaken an den Schnittkanten der Unterbrechungen der Seitenwände kann auch Beschädigungen auf der Leiterplatte bzw. der Steckbaugruppe selbst hervorrufen.

Aufgabe der vorliegenden Erfindung ist es deshalb, ein aus Metallblech kostengünstig herstellbares Kopf- bzw. Bodenteil für einen Baugruppenträger mit integrierten Führungsschienen vorzuschlagen, das einerseits ausreichende mechanische Stabilität aufweist, andererseits aber sicher vermeidet, dass bei vollständig eingeschobener Leiterplatte bestimmte Abschnitte des unteren Rands der Leiterplatte mit der Führungsschiene in Kontakt kommen.

Zur Lösung der Aufgabe wird von einem Kopf- oder Bodenteil aus Metallblech für einen Baugruppenträger mit einem umlaufenden Rahmen und mit zwei zwischen der vorderen und hinteren Rahmenleiste angeordneten und in Einschubrichtung ausgerichteten Führungsschienen zur Aufnahme einer Leiterplatte einer Steckbaugruppe ausgegangen, wobei die Führungsschienen im Querschnitt U-förmig ausgebildet sind und einen Boden und zwei Seitenwände umfassen.

Gelöst wird die Aufgabe dadurch, dass die Seitenwände der Führungsschienen mindestens eine seitliche Ausbuchtung aufweisen. Durch diese Ausbuchtung wird gewährleistet, dass die Führungsschiene Bereiche aufweist, die nicht mit dem unteren Rand der Leiterplatte der Steckbaugruppe in Kontakt kommen. Gleichzeitig werden die Seitenwände der Führungsschienen jedoch nicht unterbrochen, so dass die Steifigkeit und Stabilität der Führungsschiene voll erhalten bleibt.

Die Ausbuchtungen der Seitenwände korrespondieren mit den Kontaktstreifen (Segmenten) am unteren Rand der Leiterplatte der Steckbaugruppe. So wird gewährleistet, dass die Kontaktstreifen bzw. die stromführenden Bereiche am unteren Rand der Leiterplatte keinen Kontakt mit den Führungsschienen haben, wenn die Baugruppe ganz eingeschoben ist. Auf diese Weise wird vermieden, dass spannungsführende bzw. leitende Teile der Leiterplatte über die Führungsschienen ungewollt mit dem Gehäuse des Baugruppenträgers oder gar untereinander verbunden werden. Die Ausbuchtungen der Seitenwände ersetzen die bekannten Ausnehmungen in den Seitenwänden der herkömmlichen Führungsschienen. Gegenüber diesen wird die erfindungsgemäße Führungsschiene aber nicht durch Ausnehmungen in den Seitenwänden geschwächt und deren Steifigkeit herabgesetzt.

In einer bevorzugten Ausführungsform sind die Ausbuchtungen an beiden Seitenwänden der Führungsschienen vorgesehen. So kann auf technische Besonderheiten der einzelnen Leiterplatten eingegangen werden. Vorteilhaft ist diese Ausführung besonders beim Einsatz von Steckbaugruppen mit Doublelayer- oder Multilayer-Leiterplatten.

Insbesondere können die Ausbuchtungen der beiden Seitenwände paarweise gegenüberliegen. Die Führungsschienen haben dann einen symmetrischen Aufbau.

Besonders vorteilhaft ist ein Kopf- oder Bodenteil, bei dem der Abstand zwischen den beiden Seitenwänden einer Führungsschiene der Dicke der Leiterplatte der Steckbaugruppe entspricht und die Ausbuchtungen in den Seitenwänden der Führungsschiene nach außen gerichtet sind. Die Leiterplatte wird dann von den Seitenwänden der Führungsschiene gehalten. Die Ausbuchtungen stellen die abschnittsweisen Bereiche dar, in denen die Leiterplatte keinen Kontakt mit der Führungsschiene hat. Bei der Herstellung einer solchen Ausführungsform werden zunächst die Führungsschienen ausgebildet, wobei der Abstand zwischen den Seitenwänden der Dicke der Leiterplatte entspricht. Anschließend werden dann partiell aus den Seitenwänden die Ausbuchtungen nach außen gebogen.

Vorteilhaft erweist sich eine Ausführungsform, bei der im Bereich der Ausbuchtungen die Seitenwände vom Boden der Führungsschiene getrennt sind. Es entsteht dadurch in den Bereichen der Ausbuchtungen eine schlitzartige Öffnung am Boden der Führungsschiene. Auf diese Weise wird vermieden, dass bei der Verformung der Seitenwände auch der Boden der Führungsschiene verformt wird. Bei derart freigeschnittenen Seitenwänden im Bereich der Ausbuchtungen bleibt der Boden der Führungsschiene auch nach der Verformung der Seitenwände plan. Die Steckbaugruppen können glatt in die Führungsschiene eingeführt werden.

Schräg oder abgerundet ausgebildete Übergänge zwischen den Seitenwänden und den Ausbuchtungen der Führungsschiene weisen den Vorteil auf, dass Sprünge und scharfe Kanten vermieden werden. Auf diese Weise unterbleibt ein Verhaken der Leiterplatte bzw. Steckbaugruppe beim Einschieben in den Baugruppenträger. Beschädigungen an der Leiterplatte durch ein Verhaken oder Entlangkratzen an den eventuell scharfkantigen Übergängen während des Einschiebens werden damit ausgeschlossen.

Ein Ausführungsbeispiel der Erfindung wird nachstehend anhand der beigefügten Abbildungen näher erläutert. Es zeigen:
- Figur 1: einen Baugruppenträger mit Kopfteil und Bodenteil, perspektivisch;
- Figur 2: das Bodenteil des Baugruppenträgers aus Figur 1;
- Figur 3: eine perspektivische Darstellung einer Führungsschiene mit Ausbuchtungen, als Teil des Bodenteils aus Figur 2;
- Figur 4: eine Draufsicht der Führungsschiene nach Figur 3;
- Figur 5: eine alternative Führungsschiene mit freigeschnittenen Ausbuchtungen, perspektivisch;
- Figur 6: einen Teil der Führungsschiene aus Figur 5, in Draufsicht.

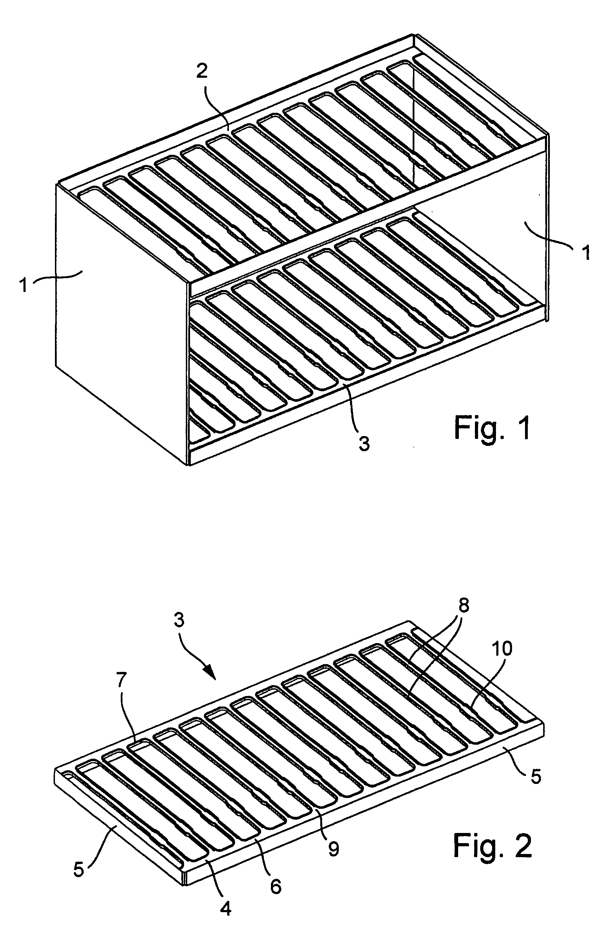

Der Baugruppenträger in Figur 1 umfasst zwei Seitenteile 1, ein Kopfteil 2 und ein Bodenteil 3. Das Kopfteil 2 und das Bodenteil 3 sind zwischen den beiden Seitenteilen 1 angeordnet, wobei das Kopfteil 2 im oberen Bereich der Seitenteile 1 und das Bodenteil 3 im unteren Bereich der Seitenteile 1 fixiert ist.

In Figur 2 ist das Bodenteil 3 im Detail zu sehen. Das Bodenteil 3 weist einen umlaufenden Rahmen 4 auf, dessen Außenbereiche nach unten hin abgekantet sind, so dass Randflächen 5 entstehen, die senkrecht zum Bodenteil 3 ausgerichtet sind. Die Randflächen 5 stellen Befestigungsflächen für die Seitenteile 1 und gegebenenfalls für eine Rückwand oder eine Frontplatte dar.

Zwischen den vorderen und hinteren Rahmenleisten 6, 7 des Rahmens 4 sind Führungsschienen 8 herausgearbeitet. Die Führungsschienen 8 verlaufen in Einschubrichtung und bilden zusammen mit dem umlaufenden Rahmen 4 eine rostartige Struktur.

Am vorderen Ende weisen die Führungsschienen 8 eine trichterförmige Aufweitung 9 auf. Steckbaugruppen, die in die Führungsschienen 8 eingeschoben werden, werden durch die Aufweitung 9 in die Führungsschienen 8 hineingeführt. Im Bereich dieser trichterförmigen Aufweitung 9 können auch zusätzlich federnde Kontaktelemente (nicht dargestellt) angeordnet sein, die über einen Widerstand mit dem Gehäuse des Baugruppenträgers verbunden sind. Damit wird bei Einsatz von Steckbaugruppen mit Entladungsflächen im unteren Bereich der Leiterplatte ein kontrolliertes Entladen der Steckbaugruppen erzwungen.

Im vorderen Bereich weisen die Führungsschienen 8 je zwei sich paarweise gegenüberliegende, nach außen gerichtete Ausbuchtungen 10 auf.

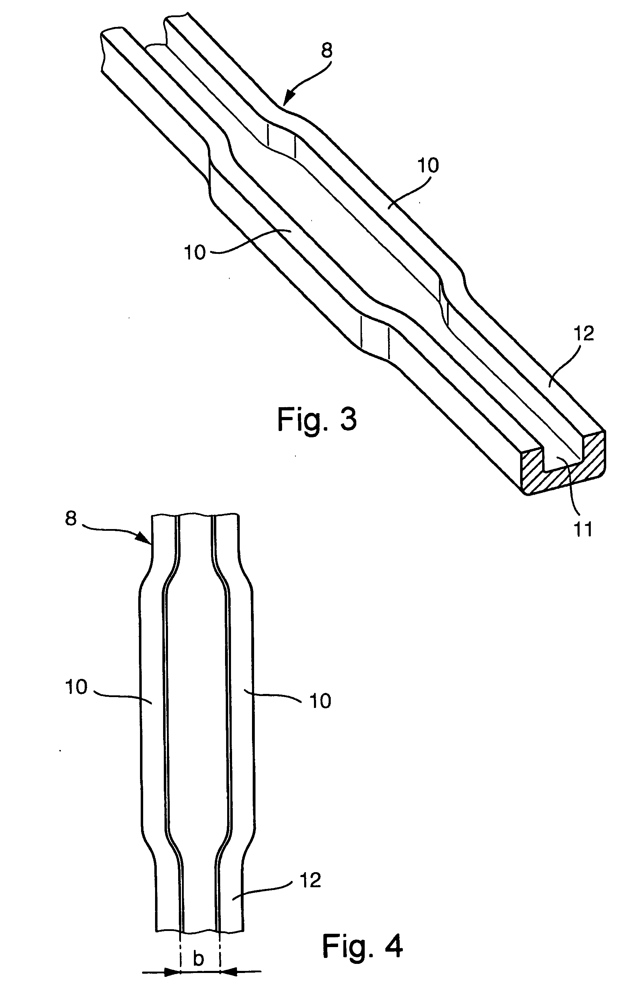

Figur 3 zeigt die Ausbuchtungen 10 der Führungsschiene 8 im Detail. Die Führungsschiene 8 ist U-förmig aufgebaut. Sie umfasst einen Boden 11 und zwei Seitenwände 12. Die Ausbuchtungen 10 sind nach außen hin ausgeformt. Der Übergang von der normal verlaufenden Seitenwand 12 zur Ausbuchtung 10 ist mit großen Radien realisiert. Im mittleren Bereich der Ausbuchtung 10 verläuft die Ausbuchtung 10 ebenso parallel wie die Seitenwände 12.

Figur 4 zeigt die symmetrische Anordnung der paarweise gegenüberliegenden Ausbuchtungen 10 der Führungsschienen 8. Der Übergang zwischen der Seitenwand 12 und der Ausbuchtung 10 verläuft stetig. Um scharfe Kanten zu vermeiden, ist der Übergang mit großen Radien gestaltet.

Der Abstand b zwischen zwei Seitenwänden 12 entspricht der Dicke einer Leiterplatte einer Steckbaugruppe. Eine Steckbaugruppe wird folglich zwischen den Seitenwänden 12 geführt. Im Bereich der Ausbuchtung 10 hat die Leiterplatte hingegen keinen Kontakt mit der Führungsschiene 8.

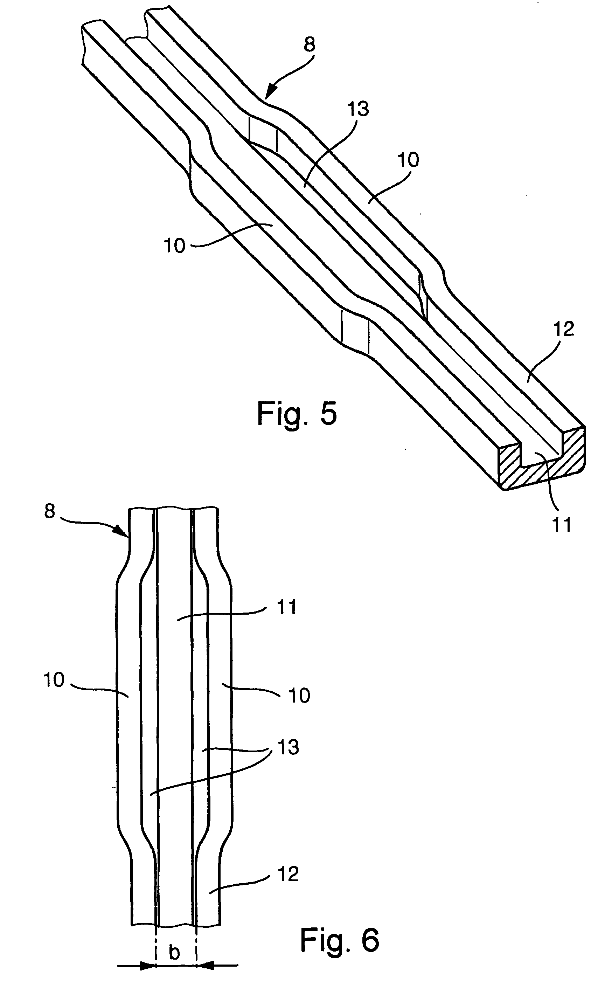

Figur 5 zeigt eine spezielle Ausführung einer Führungsschiene 8. Im Bereich der Ausbuchtungen 10 ist die Seitenwand 12 vom Boden 11 der Führungsschiene 8 frei geschnitten. Diese Trennung zwischen Boden 11 und Ausbuchtung 10 bewirkt eine schlitzartige Öffnung 13. Vor allem wird durch die Trennung der Ausbuchtung 10 vom Boden 11 vermieden, dass durch die Ausbiegung der Seitenwand 12 im Bereich der Ausbuchtung 10 auch der Boden 11 verformt wird.

Die freigeschnittenen Ausbuchtungen 10 sind in Figur 6 in der Draufsicht gezeigt. Deutlich zu erkennen sind die Öffnungen 13 zwischen dem Boden 11 und den Ausbuchtungen 10.

### Zusammenstellung der Bezugszeichen

- 1: Seitenteil
- 2: Kopfteil
- 3: Bodenteil
- 4: Rahmen
- 5: Randflächen
- 6: vordere Rahmenleiste
- 7: hintere Rahmenleiste
- 8: Führungsschiene
- 9: Aufweitung
- 10: Ausbuchtung
- 11: Boden
- 12: Seitenwand
- 13: Öffnung

## Patentansprüche

1. Kopf- oder Bodenteil aus Metallblech für einen Baugruppenträger, mit einem umlaufenden Rahmen und mit zwischen der vorderen und hinteren Rahmenleiste angeordneten und in Einschubrichtung ausgerichteten Führungsschienen (8) zur Aufnahme einer Leiterplatte einer Steckbaugruppe, wobei die Führungsschienen (8) im Querschnitt U-förmig ausgebildet sind und einen Boden (11) und zwei Seitenwände (12) umfassen, **dadurch gekennzeichnet, dass**
- die Seitenwände (12) der Führungsschienen (8) mindestens eine seitliche Ausbuchtung (10) aufweisen; und
- die Ausbuchtungen (10) der Seitenwände (12) mit mindestens einer Kontaktfläche am unteren Rand der Leiterplatte korrespondieren.

2. Kopf- oder Bodenteil nach Anspruch 1, **dadurch gekennzeichnet, dass** beide Seitenwände (12) der Führungsschiene (8) jeweils mindestens eine Ausbuchtung (10) aufweisen.

3. Kopf- oder Bodenteil nach Anspruch 2, **dadurch gekennzeichnet, dass** sich die Ausbuchtungen (10) paarweise gegenüber liegen.

4. Kopf- oder Bodenteil nach einem der Ansprüche 1 bis 3, **dadurch gekennzeichnet, dass** der Abstand zwischen den Seitenwänden (12) der Führungsschiene (8) der Dicke der Leiterplatte entspricht.

5. Kopf- oder Bodenteil nach einem der Ansprüche 1 bis 4, **dadurch gekennzeichnet, dass** im Bereich der Ausbuchtungen (10) die Seitenwände (12) vom Boden (11) der Führungsschiene (8) getrennt sind, so dass eine schlitzartige Öffnung (13) entsteht.

6. Kopf- oder Bodenteil nach einem der Ansprüche 1 bis 5, **dadurch ge-kennzeichnet, dass** der Übergang zwischen den Seitenwänden (12) und den Ausbuchtungen (10) schräg oder abgerundet ausgebildet ist.

## Claims

1. Top or bottom part made from metal sheet for an assembly support, with a surrounding frame and with guide rails (8) disposed between the front and rear frame strip and oriented in the direction of insertion in order to receive a printed circuit board of a plug- in assembly, wherein the guide rails (8) are of U-shaped construction in cross-section and comprise a base (11) and two side walls (12), **characterised in that**
- the side walls (12) of the guide rails (8) have at least one lateral bulge (10); and
- the bulges (10) of the side walls (12) correspond to at least one contact surface on the lower edge of the printed circuit board.

2. Top or bottom part as claimed in Claim 1, **characterised in that** both side walls (12) of the guide rail (8) each have at least one bulge (10).

3. Top or bottom part as claimed in Claim 2, **characterised in that** the bulges (10) lie opposite one another in pairs.

4. Top or bottom part as claimed in any one of Claims 1 to 3, **characterised in that** the distance between the side walls (12) of the guide rail (8) correspond to the thickness of the printed circuit board.

5. Top or bottom part as claimed in any one of Claims 1 to 4, **characterised in that** in the region of the bulges (10) the side walls (12) are separated from the base (11) of the guide rail (8) so that a slot-like opening is produced.

6. Top or bottom part as claimed in any one of Claims 1 to 5, **characterised in that** the transition between the side walls (12) and the bulges (10) is oblique or rounded.

## Revendications

1. Élément de couvercle ou de fond en tôle métallique pour un porte-module, comportant un cadre périphérique et comportant des rails de guidage (8) disposés entre les barres de cadre antérieure et postérieure et orientés dans la direction d'insertion pour recevoir une carte à circuit imprimé d'un module enfichable, les rails de guidage (8) étant réalisés en forme de U en section transversale et comprenant un fond (11) et deux parois latérales (12), **caractérisé en ce que**
- les parois latérales (12) des rails de guidage (8) présentent au moins une indentation (10) latérale ; et
- les indentations (10) des parois latérales (12) correspondent à au moins une surface de contact sur le bord inférieur de la carte à circuit imprimé.

2. Élément de couvercle ou de fond selon la revendication 1, **caractérisé en ce que** les deux parois latérales (12) du rail de guidage (8) présentent chacune au moins une indentation (10).

3. Élément de couvercle ou de fond selon la revendication 2, **caractérisé en ce que** les indentations (10) se font face par paires.

4. Élément de couvercle ou de fond selon l'une des revendications 1 à 3, **caractérisé en ce que** l'écartement entre les parois latérales (12) du rail de guidage (8) correspond à l'épaisseur de la carte à circuit imprimé.

5. Élément de couvercle ou de fond selon l'une des revendications 1 à 4, **caractérisé en ce que** dans la zone des indentations (10) les parois latérales (12) sont séparées du fond (11) du rail de guidage (8), de sorte qu'il se crée une ouverture (13) du genre fente.

6. Élément de couvercle ou de fond selon l'une des revendications 1 à 5, **caractérisé en ce que** la transition entre les parois latérales (12) et les indentations (10) a une configuration oblique ou arrondie.
